# EUROPEAN PATENT SPECIFICATION

(11) **EP 3 564 691 B1**
(45) Date of publication and mention of the grant of the patent: **24.02.2021**
(21) Application number: 17894091.2
(22) Date of filing: 25.01.2017
(51) Int. Cl.: G01R 31/3183, G06F 11/14, H04L 1/18, G06F 11/07, G06F 11/36, H04L 1/24

(54) **TEST DEVICE, TEST METHOD, AND TEST PROGRAM**
TESTVORRICHTUNG, TESTVERFAHREN UND PROGRAMM
DISPOSITIF DE TEST, PROCÉDÉ DE TEST ET PROGRAMME DE TEST

(43) Date of publication of application: 06.11.2019
(73) Proprietor: Mitsubishi Electric Corporation, Chiyoda-ku Tokyo 100-8310 (JP)
(72) Inventor: BABA, Madoka, Tokyo 100-8310 (JP); OKUYAMA, Hiroshi, Tokyo 100-8310 (JP)
(74) Representative: Pfenning, Meinig & Partner mbB
(86) International application number: PCT/JP2017/002604
(87) International publication number: WO 2018/138816

(56) References cited:
- EP-A1- 2 381 266
- EP-A2- 0 367 435
- GB-A- 2 032 736
- JP-A- 2014 135 580
- US-A1- 2006 095 823
- US-A1- 2006 271 709

## Description

### Technical Field

The present invention relates to a test device, test method, and test program.

### Background Art

Automobiles and ships have mounted thereon an ECU for controlling an engine ignition time and a steering motor. "ECU" is an abbreviation for Electronic Control Unit. Software implemented on the ECU is hierarchically configured of an application and a PF. The PF performs common general functions among ECUs such as a communication function and a watchdog function, improving portability and reusability of the application among ECUs. "PF" is an abbreviation for PlatForm. In recent years, as this PF, AUTOSAR (registered trademark) has been widely used as industry-standard specifications. "AUTOSAR" is an abbreviation for AUTomotive Open System ARchitecture.

In development of ECUs having AUTOSAR (registered trademark) mounted thereon, firstly, system information file in which system information common to all ECUs connected to the entire vehicle or a certain network is read to an AUTOSAR (registered trademark) product. The system information includes information about the length and arrangement of messages, signals, and so forth exchanged between the ECUs. Next, settings suitable for the application are made to automatically generate codes. Then, the AUTOSAR (registered trademark) product is connected to the application for implementation on ECU.

With sophistication of control in automated driving support systems and so forth, the functions of ECUs have become complex. When the operation of ECU has a failure, it is difficult to investigate its cause. For this reason, it is desired to find a failure in PF and a system information file by conducting a test only on PF such as AUTOSAR (registered trademark) before the application is connected, thereby facilitating a distinction from a failure included in the application.

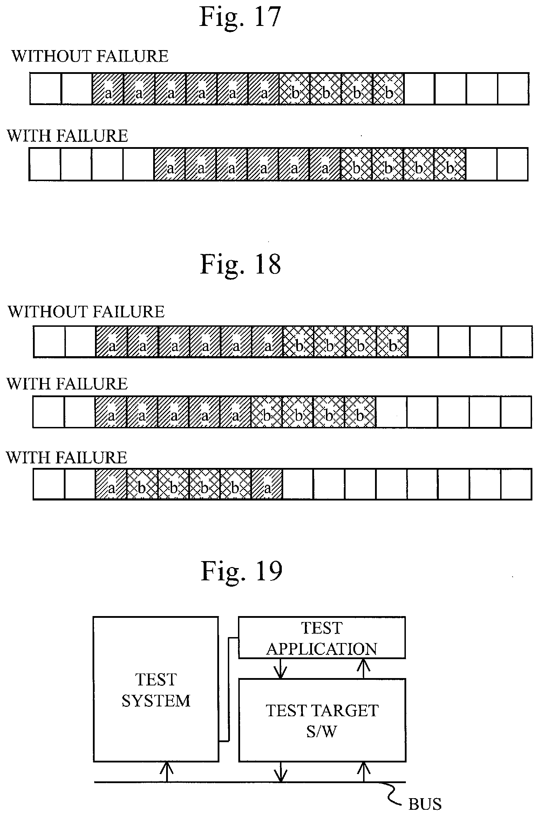

Here, failures in PF or the system information file include positional deviation of all signals illustrated in Fig. 17 and positional deviation of a specific signal illustrated in Fig. 18, with respect to a message. A main cause of the former is a failure in signal arrangement process inside PF. A main cause of the latter is a failure in signal start position setting included at the time of creating the system information file.

In AUTOSAR (registered trademark), as for tests, acceptance test specification for AUTOSAR (registered trademark) products has been defined. In the test specification for the communication function of AUTOSAR (registered trademark), test steps and judgment criteria for checking the functions of PF by using a test configuration as illustrated in Fig. 19 have been defined as a test scenario. For example, in Non-Patent Literature 1, it is defined to check that a test target signal set so as to be periodically transmitted after communication starts is periodically transmitted and that the value of the test target signal is updated and transmitted and the signal value flowing on a bus indicates a value updated therefrom.

However, as for the value when this test target signal is updated, no provision is provided, except that the value is other than an initial value. Thus, there is a possibility that the above-described failures of two types cannot be detected unless the value is updated with an appropriate value. Even if a failure is detected, it is difficult to identify whether the failure is regarding positional deviation of a signal. Even if the failure is regarding positional deviation of a signal, it is difficult to identify whether it is positional deviation of all signals or positional deviation of a specific signal. Even if the failure is regarding positional deviation of a specific signal, it is difficult to identify whether it is positional deviation of the test target signal among specific signals or overlapping with the test target signal due to positional deviation of another signal.

Normally, in a PF acceptance test, PF settings for the acceptance test are performed to conduct the test. However, with complication of PF, even if PF has a failure, the failure may not be detected with the settings for the acceptance test, and the failure may become apparent by performing settings for product shipping. When a failure is detected after PF is combined with the application by performing settings for product shipping, manhours are required for a cause distinction work as to whether the failure is in the application or PF.

As a test data determination method of detecting a failure, in Patent Literature 1, a method is disclosed in which exclusive OR computation is performed on a counter value and test data with a Hamming distance from the previous test data value being always (the number of bits - 1) is calculated.
US2006095823A1 discloses a test having a pattern generating section for generating a test pattern, an expected value generating section for generating an expected value, an inversion cycle generating section for generating an expected value pattern of an output signal in which bits in a cycle of the expected value pattern in the output data corresponding to the cycle in which the electronic device outputs the data by inverting the bits thereof, an H-level judging section for outputting H fail data per bit of the expected value pattern of the output signal, a L-level judging section for outputting L fail data per bit of the expected value pattern of the output signal, a fail memory and selecting sections for switching a logic value of the H fail data and a logic value of the L fail data when the inversion cycle generating section inverts the bits of the expected value pattern.
EP2381266A1 discloses a self-diagnosis system and a test circuit determination method that are capable of determining normality of a test circuit which diagnoses a test target circuit. A self-diagnosis system according to an aspect of the present invention includes a test circuit including first and second diagnosis controllers which determine normality of a test target circuit by using an execution result of a test pattern in the test target circuit; and a test circuit determination unit which determines normality of the test circuit by comparing a normality determination result of the test target circuit output from the first diagnosis controller with a normal determination result of the test target circuit output from the second diagnosis controller.
EP0367435A2 discloses an method of verifying the accurate transmission of an n-bit word followed by transmitting an inversion of the n-bit word. receiving the words in an n-bit shift register and checking for inversion of the n + 1 bit and all subsequent bits up to n + n bits by synchronised comparison with the corresponding output of the shift register, and providing an accept signal only if all the compared bits are inversions of one another, the word then stored in the shift register being the accurate inversion of the n-bit word.
US2006271709A1 discloses an inter-network interface device usable in a highly reliable industrial control system provides an interface between a producer module transmitting redundant messages in accordance with a communication protocol and a consumer module receiving the messages in accordance with a different communication protocol. The inter-network interface device includes a first network interface receiving two messages from the producer, a microprocessor capable of converting the messages from the producer communication protocol to consumer communication protocol, and a second network interface transmitting the messages to the consumer. One of the messages is reversible altered with respect to the other message. The altered message is uninverted in the consumer module, and compared to the other message to ensure that no transmission errors have occurred.
GB2032736A discloses a method of checking the accuracy of transmission of data between a transmitter and a receiver, in which the data is multi-bit binary data and is transmitted in parallel, in which on reception of a multi-bit data block that data block is temporarily stored and a control signal is sent back to the transmitter, in which the reception at the transmitter of a said control signal causes the data block to be retransmitted inverted, i.e. with each 1 bit replaced by a 0 bit and vice-versa, in which at the receiver the two versions of the data block are compared, the original version being accepted as valid if every bit of the original version of the data block differs from the corresponding bit of the inverted version if the data block, and in which if the comparison reveals identity between a pair of bits, one from the original version of the data block and one from the inverted version thereof, a fault indication is given.

### Citation List

### Patent Literature

Patent Literature 1: JP 2010-117316

### Non-Patent Literature

Non-Patent Literature 1: AUTOSAR, "Acceptance Test Specification of Communication on CAN bus Release 1.1.0", pp. 12-13, [online], AUTOSAR, [searched on January 20, 2017], Internet <URL: http://www.autosar.org/fileadmin/files/standards/tests/tc-1-1/specifications_auxiliary/A UTOSAR_ATS_CommunicationCan.pdf>

### Summary of Invention

### Technical Problem

In the technique disclosed in Patent Literature 1, for one test target signal, test data for the number of times indicated by the counter value is substituted. Thus, the number of test execution manhours for all test target signals increases. That is, it is impossible to efficiently detect a failure. Moreover, a range of signals that can be inputted from the application is not considered. Thus, there is a case that a value indicating a floating-point infinity may be calculated. That is, a value outside a signal range that cannot be stored as a value of the test target signal in a test application may be calculated. Furthermore, even if a failure is detected, the cause of the detected failure cannot be identified.

The present invention has an object of efficiently detecting a failure.

### Solution to Problem

A test device according to one aspect of the present invention includes:
a communication unit to sequentially receive messages partially including a test target signal of a plurality of bits transmitted from a test target device; and
a judgment unit to check a value of the test target signal included in a message received by the communication unit in a first duration against a first expected value, to check a value of the test target signal included in a message received by the communication unit in a second duration different from the first duration against a second expected value acquired by inverting each bit of the first expected value, and to judge a test on the test target device as pass or fail based on both of the check results.

### Advantageous Effects of Invention

In the present invention, the test is performed by using both of the first expected value and the second expected value, which is acquired by inverting each bit of the first expected value. Thus, both of positional deviation of all signals and positional deviation of only a specific signal with respect to the message can be detected. That is, the above-described failures of two types can be efficiently detected.

### Brief Description of Drawings

Fig. 1 is a block diagram illustrating the configuration of a test device according to Embodiment 1.
Fig. 2 is a flowchart illustrating operation of an extraction unit of the test device according to Embodiment 1.
Fig. 3 is a flowchart illustrating operation of a determination unit of the test device according to Embodiment 1.
Fig. 4 is a flowchart illustrating operation of an execution unit, a judgment unit, and an output unit of the test device according to Embodiment 1.
Fig. 5 illustrates an example of arrangement of a test target signal in a CAN message according to Embodiment 1.
Fig. 6 illustrates an example of arrangement of the test target signal in the CAN message according to Embodiment 1 when all signals are positionally deviated.
Fig. 7 illustrates an example of arrangement of the test target signal in the CAN message according to Embodiment 1 when another signal is positionally deviated.
Fig. 8 is a flowchart illustrating operation of an extraction unit of a test device according to Embodiment 2.
Fig. 9 is a flowchart illustrating operation of an execution unit of the test device according to Embodiment 2.
Fig. 10 is a flowchart illustrating operation of the execution unit of the test device according to Embodiment 2.
Fig. 11 is a flowchart illustrating operation of a judgment unit and an output unit of the test device according to Embodiment 2.
Fig. 12 is a flowchart illustrating operation of the judgment unit and the output unit of the test device according to Embodiment 2.
Fig. 13 illustrates an example of arrangement of a test target signal and an update bit in a CAN message according to Embodiment 2.
Fig. 14 illustrates an example of arrangement of the test target signal and the update bit in the CAN message according to Embodiment 2 when all signals are positionally deviated.
Fig. 15 illustrates an example of arrangement of the test target signal and the update bit in the CAN message according to Embodiment 2 when the test target signal is positionally deviated.
Fig. 16 illustrates an example of arrangement of the test target signal and the update bit in the CAN message according to Embodiment 2 when another signal is positionally deviated.
Fig. 17 illustrates an example of a failure in a PF or a system information file.
Fig. 18 illustrates an example of a failure in the PF or the system information file.
Fig. 19 is a block diagram illustrating a test configuration in AUTOSAR (registered trademark) acceptance test specification.

### Description of Embodiments

In the following, embodiments of the present invention are described by using the drawings. In each drawing, identical or corresponding portions are provided with the same reference characters. In the description of the embodiments, description of identical or corresponding portions is omitted or simplified as appropriate. Note that the present invention is not limited to the embodiments described in the following, but can be variously modified as required. For example, of the embodiments described in the following, two or more embodiments may be combined and implemented. Alternatively, of the embodiments described in the following, one embodiment or a combination of two or more embodiments may be partially implemented.

### Embodiment 1.

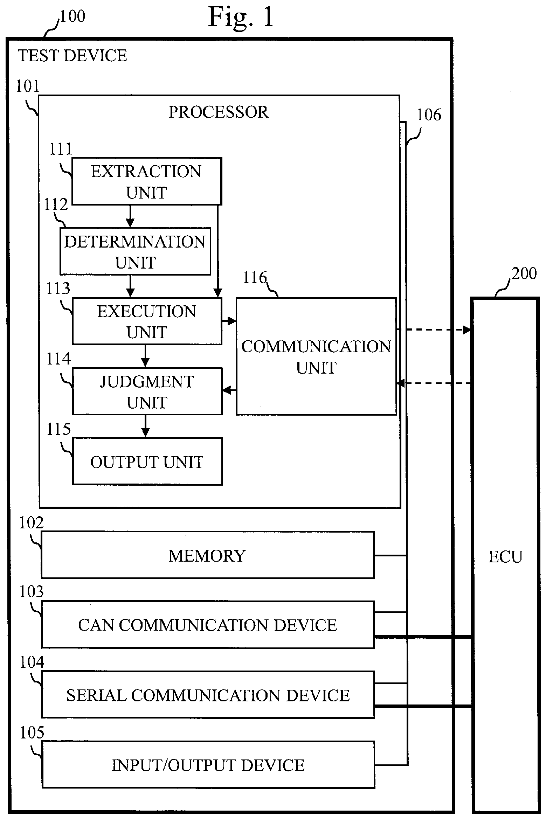

The present embodiment is described by using Fig. 1 to Fig. 7.

### ***Description of Configuration***

With reference to Fig. 1, the configuration of a test device 100 according to the present embodiment is described.

The test device 100 is a device which, while communicating with an ECU 200 connected thereto, tests a PF implemented on the ECU 200 as a test target device.

Note that the ECU 200 can be replaced by any device which sequentially transmits messages partially including a test target signal of a plurality of bits. That is, the test device 100 can be a device which tests any device not limited to the ECU 200.

The test device 100 is a computer. The test device 100 includes a processor 101 and also other pieces of hardware such as a memory 102, a CAN communication device 103, a serial communication device 104, and an input/output device 105. "CAN" is an abbreviation for Controller Area Network. The processor 101 is connected to the other pieces of hardware via an internal bus 106 to control the other pieces of hardware.

The test device 100 includes, as functional components, an extraction unit 111, a determination unit 112, an execution unit 113, a judgment unit 114, an output unit 115, and a communication unit 116. The functions of the extraction unit 111, the determination unit 112, the execution unit 113, the judgment unit 114, the output unit 115, and the communication unit 116 are implemented by software.

The processor 101 is an IC which performs various processes. "IC" is an abbreviation for Integrated Circuit. The processor 101 is, for example, a CPU. "CPU" is an abbreviation for Central Processing Unit.

The memory 102 is, for example, a flash memory or RAM. "RAM" is an abbreviation for Random Access Memory.

The CAN communication device 103 and the serial communication device 104 are connected to the external ECU 200. The CAN communication device 103 operates by following communication protocol CAN, and the serial communication device 104 operates by following the JTAG standards. "JTAG" is an abbreviation for Joint Test Action Group. The CAN communication device 103 and the serial communication device 104 are used to perform communications with the ECU 200 via the communication unit 116. The CAN communication device 103 and the serial communication device 104 are, for example, communication chips or NICs. "NIC" is an abbreviation for Network Interface Card.

Although not illustrated, the input/output device 105 is connected to external devices such as a display, a keyboard, and so forth connected to the test device 100. The input/output device 105 is used to display test results via the output unit 115.

In the memory 102, a test program is stored, which is a program for implementing the functions of the extraction unit 111, the determination unit 112, the execution unit 113, the judgment unit 114, the output unit 115, and the communication unit 116. The test program is read to the processor 101 and is executed by the processor 101. An OS is also stored in the memory 102. "OS" is an abbreviation for Operating System. While executing the OS, the processor 101 executes the test program. Note that the test program may be partially or entirely incorporated in the OS.

The test program and the OS may be stored in an auxiliary storage device. The auxiliary storage device is, for example, a flash memory or HDD. "HDD" is an abbreviation for Hard Disk Drive. The test program and the OS stored in the auxiliary storage device are loaded to the memory 102 and executed by the processor 101.

The test device 100 may include a plurality of processors which replace the processor 101. The plurality of these processors share the execution of the test program. As with the processor 101, each of the processors is an IC which performs various processes.

Information, data, signal values, and variable values indicating the results of processes of the extraction unit 111, the determination unit 112, the execution unit 113, the judgment unit 114, the output unit 115, and the communication unit 116 are stored in the memory 102, the auxiliary storage device, or a register or cache memory in the processor 101.

The test program may be stored in a portable recording medium such as a magnetic disk or optical disk.

### ***Description of Operation***

With reference to Fig. 1, a general outline of the operation of the test device 100 according to the present embodiment is described. The operation of the test device 100 corresponds to test method according to the present embodiment.

The extraction unit 111 reads required information from system information file including information regarding messages and signals transmitted and received by the ECU 200.

The determination unit 112 determines test data for use in a test, based on the information read by the extraction unit 111.

The execution unit 113 executes a test scenario by using the information extracted by the extraction unit 111 and the test data determined by the determination unit 112. The execution unit 113 performs processes, such as triggering the operation of the ECU 200 and passing an update value for use in the test via the communication unit 116 to the ECU 200.

The judgment unit 114 judges the test executed by the execution unit 113 as pass or fail, that is, whether the test result is "PASS" or "FAIL", based on the signal received from the ECU 200 via the communication unit 116.

The output unit 115 outputs the test result by the judgment unit 114 to the display or the like.

The communication unit 116 performs serial communication process in order to pass the value received from the execution unit 113 to the ECU 200. The communication unit 116 performs CAN communication process in order to extract the value from the signal included in the CAN message received from the ECU 200 and passes the value to the judgment unit 114.

A general outline of a test on the PF implemented on the ECU 200 by using the test device 100 is described.

Software of the ECU 200 is configured of the PF and a test application. The PF is set so as to operate by following a system information file.

The system information file has included therein, previously by a car manufacturer or the like for ECU 200 products, information about arrangement of signals to be transmitted and received by the ECU 200 in the message and information about a signal type, a signal length, and so forth.

The test device 100 reads a system information file. The test device 100 determines a test target signal as a signal for use in a test, and test data suitable for test contents and the test target signal. The test device 100 then executes a test by following the test scenario.

In the test scenario of the present embodiment, it is checked that periodically-transmitted CAN messages are periodically transmitted by following a period defined in the system information file. It is checked that the value of the test target signal included in the CAN message is an initial value after starting the test and until the test device 100 passes an update value to the ECU 200. It is checked that after the test device 100 passes the update value, the value of the test target signal included in the CAN message is updated to that value. Also, in the test scenario of the present embodiment, it is defined that the initial value and the update value different from each other are used.

With execution of the test application of the ECU 200 triggered by the test device 100, the PF of the ECU 200 starts transmitting the CAN message including the test target signal by using the initial value defined in the system information file. The position of the test target signal in the CAN message is also defined in the system information file. By following that information, the PF arranges the test target signal in the CAN message. The PF continues transmission of the CAN message including the test target signal by using the initial value until the test application receives an update value from the test device 100. With the test device 100 passing the update value to the test application, the test application passes that update value to the PF. The PF updates the test target signal in the CAN message with the update value for transmission. Upon receiving the CAN message, the test device 100 checks whether the stored value of the test target signal matches the initial value before passing the update value to the test application and matches that update value after passing the update value to the test application. The test device 100 judges that the test result is "PASS" if they match, and judges that the test result is "FAIL" if they do not match. Note that signals to be transmitted by the ECU 200 except the test target signal are assumed to be fixed at an initial value during test execution.

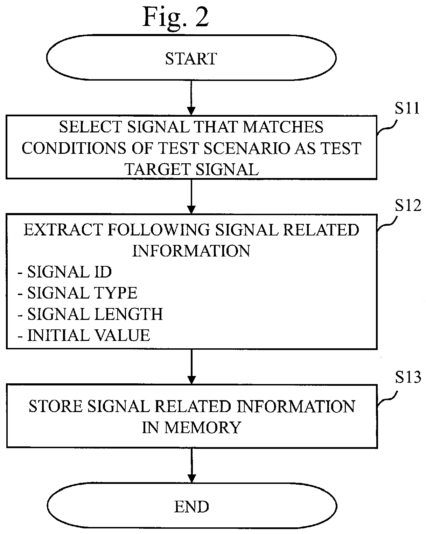

With reference to Fig. 2 to Fig. 4, details of the operation of the test device 100 according to the present embodiment are described.

The operation of the extraction unit 111 is described by using Fig. 2.

At step S11, the extraction unit 111 selects a signal that matches conditions of the test scenario from a signal list included in the system information file as a test target signal. In the test scenario in the present embodiment, a signal included in a CAN message periodically transmitted is selected as a test target signal. Next, the process at step S12 is performed.

At step S12, the extraction unit 111 extracts a signal ID for identifying the selected test target signal, a signal type, a signal length, and an initial value from the system information file. Next, the process at step S13 is performed.

At step S13, the extraction unit 111 stores the extracted information in the memory 102 as signal related information, and ends the operation.

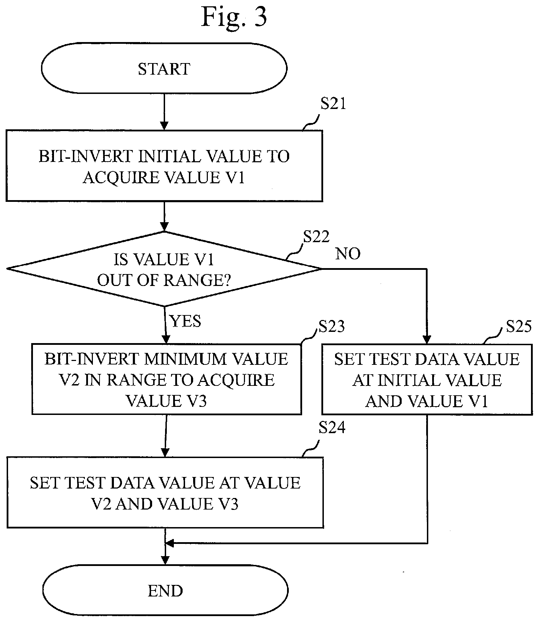

The operation of the determination unit 112 is described by using Fig. 3.

At step S21, by using information about the signal length and the initial value from the signal related information stored by the extraction unit 111 in the memory 102, the determination unit 112 derives a value V1 by bit-inverting the initial value, the value V1 having the same signal length. Next, the process at step S22 is performed.

At step S22, the determination unit 112 judges whether the value V1 is out of a range that can be represented by the signal type. If the value V1 is out of the range, the process at step S23 is performed. If the value V1 is in the range, the process at step S25 is performed.

At step S23, the determination unit 112 sets a minimum value in the range that can be represented by the signal type as a value V2, and sets a value acquired by bit-inverting the value V2 and having the same signal length as a value V3. Next, the process at step S24 is performed.

At step S24, the determination unit 112 sets the test data value at the value V2 and the value V3, and ends the operation.

At step S25, the determination unit 112 sets the test data value at the initial value and the value V1, and ends the operation.

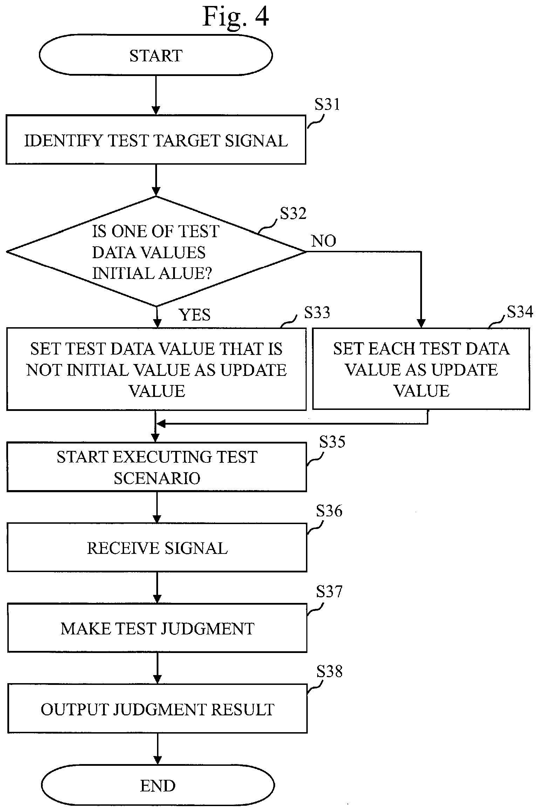

The processes of the execution unit 113, the judgment unit 114, and the output unit 115 are described by using Fig. 4.

At step S31, the execution unit 113 identifies the test target signal by using the signal ID from the signal related information extracted by the extraction unit 111. Next, the process at step S32 is performed.

At step S32, the execution unit 113 checks whether the initial value of the test target signal is included in two test data values determined by the determination unit 112. If included, the process at step S33 is performed. If not included, the process at step S34 is performed.

At step S33, the execution unit 113 takes a value of the test data values that is not the initial value as an update value. Next, the process at step S35 is performed.

At step S34, the execution unit 113 determines to execute the test scenario twice. The execution unit 113 takes the two test data values as update values in the first and second test scenario executions, respectively. Next, the process at step S35 is performed.

At step S35, the execution unit 113 starts executing a test via the communication unit 116 by using the test target signal and the update values by following the test scenario. If it is determined at step S34 that the test scenario is to be executed twice, the test is executed twice. Next, the process at step S36 is performed.

At step S36, the judgment unit 114 receives the test target signal included in the CAN message transmitted by the ECU 200 via the communication unit 116. Next, the process at step S37 is performed. Note that after test execution starts at step S35, execution of the test scenario and reception of the signal at step S36 are performed in parallel.

At step S37, the judgment unit 114 makes a test judgment by following the test scenario. Next, the process at step S38 is performed.

At step S38, the output unit 115 outputs the test judgment result at the judgment unit 114, and ends the operation.

As described above, at step S36, the communication unit 116 sequentially receives messages partially including a test target signal of a plurality of bits transmitted from the ECU 200 as a test target device. At step S37, the judgment unit 114 checks the value of the test target signal included in a message received by the communication unit 116 in a first duration against a first expected value. The judgment unit 114 checks the value of a test target signal included in a message received by the communication unit 116 in a second duration different from the first duration against a second expected value acquired by inverting each bit of the first expected value. Then, based on both of the check results, the judgment unit 114 judges the test on the ECU 200 as pass or fail.

At step S21, the determination unit 112 computes the value V1 acquired by inverting each bit of the initial value of the test target signal. At step S25, the determination unit 112 determines the initial value as a first expected value and determines the value V1, which is the computation result, as a second expected value.

If the value V1 is out of the range of the test target signal at step S22, the determination unit 112 determines the first setting value V2, which is in the range and a value different from the initial value, as a first expected value, and determines the second setting value V3, which is in the range and is acquired by inverting each bit of the first setting value V2, as a second expected value at step S24. Note that while the initial value is assumed to be in the range in the present embodiment, the initial value may be out of the range. That is, if at least either of the initial value and the value V1 is out of the range, the determination unit 112 may determine the first setting value V2 as a first expected value and the second setting value V3 as a second expected value.

In the present embodiment, a notification about the first expected value and the second expected value determined by the determination unit 112 is made by the execution unit 113 to the ECU 200 at step S35. However, the first expected value and second expected value previously determined may be retained by the ECU 200 before communication between the test device 100 and the ECU 200 starts.

The operation of the test device 100 is described by using a specific example.

In Example 1, in the system information file, a periodically-transmitted CAN message and an unsigned integer-type signal included therein and having a 6-bit length and an initial value of 3 (000011b) are present. Therefore, the extraction unit 111 of the test device 100 selects this signal as a test target signal that matches the conditions of the test scenario. The extraction unit 111 stores the signal related information in the memory 102. Next, the determination unit 112 calculates the value V1 from the signal related information. The value V1 has a 6-bit length and an initial value of 3, is of an unsigned integer type, and thus becomes 111100b. 111100b represents 60, and can be represented as a value of an unsigned integer type. Therefore, the initial value of 3 and the value of 60 are test data values. Since the test data values (3 and 60) for the test target signal include the initial value of 3, the execution unit 113 executes the test scenario once by taking the value of 60 that is not the initial value as an update value. With execution of the test scenario, the ECU 200 stores the initial value of 3 in the test target signal and starts periodical transmission of the CAN message. When the execution unit 113 passes the update value of 60 to the test application between a time t0 and a time t1, the test application passes this to the PF. The PF updates the value of the test target signal included in the CAN message and continues periodical transmission. The judgment unit 114 judges whether the received value of the test target signal matches the initial value of 3 until the execution unit 113 passes the update value of 60 to the ECU 200 between the time t0 and the time t1. After the execution unit 113 passes the update value of 60 to the ECU 200, the judgment unit 114 judges whether the received value of the test target signal matches the update value of 60. If they always match, the test judgment result regarding the test data is "PASS", and the operation ends. Note that judgment timing is not limited to this. The judgment unit 114 may store the received test target signal once in the memory 102 and, after completion of test execution, compare the initial value and the update value each with the stored value.

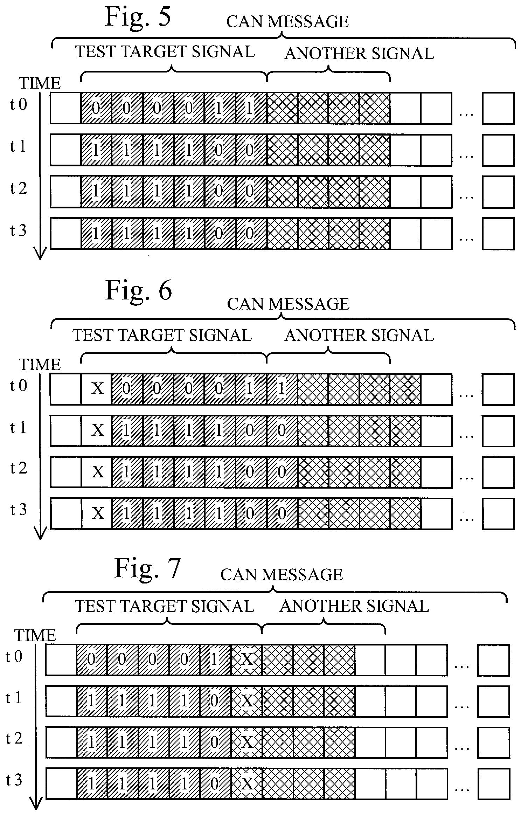

Description is made by using Fig. 5 to the value of the test target signal included in the CAN message received by the test device 100 when the PF and the system information file are normal in the above-described operation.

The judgment unit 114 receives a value of 3 as a test target signal at the time t0. With the execution unit 113 passing the update value to the ECU 200 between the times t0 to t1, the value is updated. The judgment unit 114 receives a value of 60 at the time t1 and thereafter. With the judgment unit 114 receiving the initial value and the update value, the test result is judged as "PASS".

The case in which the PF or the system information file has a failure and the positions of all signals included in the CAN message are deviated by one bit is described by using Fig. 6. A "test target signal" in the drawing indicates a value to be received by the test device 100 as a test target signal.

The judgment unit 114 receives a value of XOOOlb at the time t0 as the initial value of the test target signal. The judgment unit 114 receives a value of X11110b at the time t1 and thereafter, the time t1 when the ECU 200 receiving the update value from the execution unit 113 updates the value. X is an initial value of each signal or reserved bit. That is, X is a value fixed at either 0 or 1 through test scenario execution. Since the judgment unit 114 receives a value other than the initial value of 3 and the update value of 60 as expected values, the test result can be judged as "FAIL".

In this manner, by executing the test on one test target signal by using two values, that is, the initial value and the update value with bits inverted to each other, it is possible to detect a failure in the process associated with arrangement of the test target signal included in the PF or the system information file. A deviation width of that arrangement can also be estimated. If the test is performed by using an initial value of 0 (000000b) and an update value of 1 (000001b) without bit inversion, the test device 100 receives a value of X00000b at the time t0 and receives X00000b at the time tl as a test target signal. When the value of X is 0, the test device 100 always receives 0 as the value of the test target signal even at the time t0 and the time t1 and thereafter. Thus, the test device 100 cannot judge whether the value received at the time t1 is abnormal due to a deviation of the signal arrangement or the value is not updated due to another failure even though the value has been updated. Moreover, the test device 100 cannot judge how much deviation occurs even in the case of deviation of the signal arrangement. Thus, time is required to analyze the cause.

Here, description is made to the case in which all signals included in the CAN message are positionally deviated. However, also in the case in which only the test target signal is positionally deviated due to a failure in the PF or the system information file, this can be detected as a failure.

Description is made by using Fig. 7 to the case in which the PF or the system information file has a failure and arrangement of a signal different from the test target signal is deviated to be overlapped with the test target signal.

The judgment unit 114 receives, as an initial value of the test target signal, a value of OOOOlXb at the time t0. The judgment unit 114 receives a value of 11110Xb at the time t1 and thereafter, the time t1 when the ECU 200 receiving the update value from the execution unit 113 updates the value. X is the first one bit of the initial value of another signal. That is, X is a value fixed at either 0 or 1 through test scenario execution. Since the judgment unit 114 receives a value other than the initial value of 3 and the update value of 60 as expected values, the test result is judged as "FAIL".

In this manner, by executing the test on one test target signal by using two values, that is, the initial value and the update value with bits inverted to each other, it is possible to detect a failure in the process associated with arrangement of another signal overlapping the test target signal included in the PF or the system information file. A deviation width of that arrangement can also be estimated. If the test is performed by using an initial value of 0 (000000b) and an update value of 32 (100000b) without bit inversion, the test device 100 receives a value of 00000Xb at the time t0 and receives 10000Xb at the time t1 as a test target signal. When the value of X is 0, the test device 100 judges that the initial value and the update value are correctly received as a test target signal, even though another signal overlaps. That is, the test device 100 cannot detect a failure. As a result, the test device 100 receives an abnormal value at the stage of executing a function test in combination with an application for actual use. Thus, a work of making a distinction whether the failure is a failure in the application or a failure in the PF, reworking such as retest on the PF, and so forth occur. Therefore, the number of test man-hours increases.

In the present embodiment, it is assumed that the PF writes a CAN message in a signal in the order of the test target signal and then another signal. If writing is performed in the reverse order of another signal and then the test target signal, a failure due to overlapping cannot be detected. Thus, to detect that a failure is present even in this case, the other signal may also be taken as a judgment target by the test device 100. By checking that the test target signal matches the update value at the time of reception and, in addition, the value of the other signal matches the initial value acquired from the system information file, failure detectability can be improved. Note that the value of this other signal is fixed at the initial value and the execution unit 113 is not required to perform a process of giving an update value and so forth.

As described above, the judgment unit 114 may check the value of a signal adjacent to the test target signal in the message received by the communication unit 116 against a third expected value. Then, based on the check result of the value of the test target signal and the check result of the value of the signal adjacent to the test target signal, the judgment unit 114 may judge pass or fail of the test on the ECU 200. Specifically, the judgment unit 114 may judge pass or fail of the test on the ECU 200 based on the results acquired by checking a value of the test target signal in a first duration against the first expected value, a value of the test target signal in a second duration against the second expected value, and a value of a signal adjacent to the test target signal in a first duration or the second duration against a third expected value.

In Example 2, in the system information file, a periodically-transmitted CAN message and a floating-point-type signal included therein and having a 32-bit length and an initial value of 0 (00...00b) are present. Therefore, the extraction unit 111 of the test device 100 selects this signal as a test target signal that matches the conditions of the test scenario. The extraction unit 111 stores the signal related information in the memory 102. Next, the determination unit 112 calculates the value V1 from the signal related information. The value V1 has a 32-bit length and an initial value of 0, is of a floating point type, and thus becomes OxFFFFFFFF. However, this value is a value handled as NaN in the floating point type. "NaN" is an abbreviation for Not a Number. A value handled as NaN cannot be handled by a test application. The operation becomes indeterminate and, depending on the PF, measures are taken such as automatic correction to, for example, a maximum value that can be represented, and there is a possibility of not correctly executing a test. Thus, the determination unit 112 derives 1.1754944...E-38 (0x00800000) as a minimum value that can be represented in the floating point type and takes the value as the value V2. The determination unit 112 takes -3.4028235E+38 (0xFF7FFFFF) acquired by further bit-inverting this value as the value V3. The determination unit 112 uses the value V2 and the value V3 as test data values. Since the test data values do not include the initial value of 0, the execution unit 113 executes the test scenario twice. The determination unit 112 executes a test by taking the initial value of 0 and an update value of 1.1754944...E-38 (0x00800000) for the first test scenario and taking the initial value of 0 and an update value of -3.4028235E+38 (0xFF7FFFFF) for the second test scenario. The operation thereafter and the failure detection method are identical to those of Example 1, except that a failure is detected by comparing each of the update values in two test scenario executions and a reception value of each test target signal received after each update. Thus, description is omitted.

In this manner, by avoiding the test data value from being out of the range of the signal type, the test can be reliably executed, and the above-described failure can be detected.

### ***Description of Effects of Embodiment***

In the present embodiment, the test is performed by using both of the first expected value and the second expected value, which is acquired by inverting each bit of the first expected value. Thus, both of positional deviation of all signals and positional deviation of only a specific signal with respect to the message can be detected.

In the present embodiment, the test is performed by using two test data values targeted for the PF subjected to settings for product shipping. Thus, a failure regarding signal arrangement process and signal arrangement information in the PF and the system information file can be detected. Three failure causes can also be identified. Thus, the number of test execution manhours and the number of failure analysis manhours using the test results can be reduced.

That is, according to the present embodiment, for the PF subjected to settings for product shipping, a failure regarding signal arrangement process and signal arrangement information that is included in the PF and the system information file and becomes apparent by the settings of the PF for product shipping can be detected as a failure regarding arrangement being present. It is possible to identify whether the cause of the failure is positional deviation of all signals or positional deviation of a specific signal. Furthermore, it is possible to identify whether the cause of the failure is positional deviation of the test target signal among specific signals or overlapping with the test target signal due to positional deviation of another signal. Thus, a failure regarding signal arrangement process and signal arrangement information can be detected with a smaller number of test execution manhours compared with the conventional technology. Still further, the number of manhours for analysis of the cause of the detected failure can also be reduced.

In the present embodiment, by executing the test by using two values with bits inverted to each other, it is possible to detect a failure in the process associated with arrangement of the test target signal included in the PF or the system information file as a failure regarding arrangement. Furthermore, a deviation width of arrangement can also be estimated. With this, compared with the cases in which a failure is detected after application coupling and in which a distinction from another failure cannot be made, the number of manhours in the whole test step can be reduced.

In the present embodiment, if a value acquired by inverting the initial value can be used as an update value, a failure can be detected during execution of one test. Thus, the time required for test execution can be reduced.

In the present embodiment, by selecting a test data value in the range that can be represented by the signal based on the signal type and length, the test can be reliably executed.

In a modification example of the present embodiment, in consideration of the signal writing order by the PF, the value of another signal transmitted simultaneously with the test target signal is also taken as a monitoring target. Thus, a failure associated with signal arrangement process can be detected.

In the present embodiment, a signal conforming to the test scenario is selected as a test target signal by using the system information file for product shipping to determine test data. Thus, compared with the case in which a test target signal and a message are newly created for the test scenario, the manhours for PF setting for the test are not required. Furthermore, by using the system information file for product shipping, the PF subjected to the settings for product shipping is taken as a test target. Thus, a failure in the process associated with signal arrangement that becomes apparent only in the PF settings for product shipping can be detected. Compared with creating a test target signal and a message only for the test scenario to execute the test, the inclusion ratio of a failure at the time of product shipping can be reduced.

### ***Other Configurations***

In the present embodiment, CAN and JTAG are used as communications between the ECU 200 and the test device 100. However, another communication protocol may be used.

In the present embodiment, the determination unit 112 finds, as test data values, an initial value and its bit-inverted value or two values with bits inverted to each other other than the initial values. However, if a specific value that should not be adopted as a test data value is present depending on the test scenario, the test data value may be determined so as to be a value except that specific value.

In the present embodiment, when the bit-inverted value of the initial value is out of the representation range of the signal type, the determination unit 112 finds a minimum value in the range and its bit-inverted value as test data values, but may invert any bit at the same position as the initial value and its bit-inverted value until the value becomes in the range. That is, when at least one of the two values found as test data values is out of the representation range of the signal type, the determination unit 112 may invert any bit at the same position as these two values until the value becomes in the range.

In the present embodiment, the execution unit 113 uses the test scenario in which the update value is passed from the test device 100 to the test application, from the test application to the PF, and then from the PF to the test device 100. However, a reverse test scenario may be used. That is, the execution unit 113 may use a test scenario in which a signal received by the PF is passed to the test application and the value received by the test application is used for test judgment.

In the present embodiment, the functions of the extraction unit 111, the determination unit 112, the execution unit 113, the judgment unit 114, the output unit 115, and the communication unit 116 are implemented by software. However, as a modification example, the functions of the extraction unit 111, the determination unit 112, the execution unit 113, the judgment unit 114, the output unit 115, and the communication unit 116 may be implemented by a combination of software and hardware. That is, the functions of the extraction unit 111, the determination unit 112, the execution unit 113, the judgment unit 114, the output unit 115, and the communication unit 116 may be partially implemented by a dedicated electronic circuit and the rest may be implemented by software.

The dedicated electronic circuit is, for example, a single circuit, composite circuit, programmed processor, parallelly-programmed processor, logic IC, GA, FPGA, or ASIC. "GA" is an abbreviation for Gate Array. "FPGA" is an abbreviation for Field-Programmable Gate Array. "ASIC" is an abbreviation for Application Specific Integrated Circuit.

The processor 101, the memory 102, and the dedicated electronic circuit are collectively referred to as "processing circuitry". That is, irrespectively of whether the functions of the extraction unit 111, the determination unit 112, the execution unit 113, the judgment unit 114, the output unit 115, and the communication unit 116 are implemented by software or a combination of software and hardware, the functions of the extraction unit 111, the determination unit 112, the execution unit 113, the judgment unit 114, the output unit 115, and the communication unit 116 are implemented by processing circuitry.

The "device" in the test device 100 may be read as "method", and the "unit" in the extraction unit 111, the determination unit 112, the execution unit 113, the judgment unit 114, the output unit 115, and the communication unit 116 may be read as "step". Alternatively, the "device" in the test device 100 may be read as "program", "program product", or "computer-readable medium having a program recorded thereon", and the "unit" in the extraction unit 111, the determination unit 112, the execution unit 113, the judgment unit 114, the output unit 115, and the communication unit 116 may be read as "procedure" or "process".

### Embodiment 2.

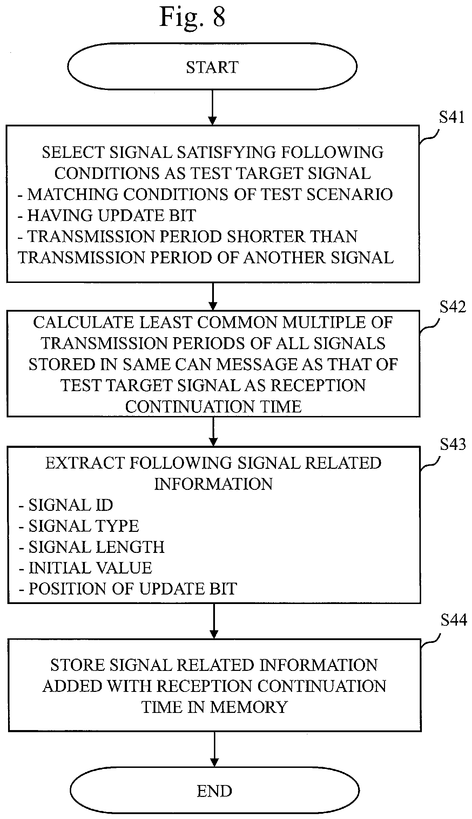

As for the present embodiment, differences from Embodiment 1 are mainly described by using Fig. 8 to Fig. 16.

### ***Description of Configuration***

The configuration of the test device 100 according to the present embodiment is identical to that of Embodiment 1 illustrated in Fig. 1.

### ***Description of Operation***

With reference to Fig. 8 to Fig. 12, the operation of the test device 100 according to the present embodiment is described. The operation of the test device 100 corresponds to a test method according to the present embodiment.

The operation of the extraction unit 111 is described by using Fig. 8.

At step S41, the extraction unit 111 selects, from a signal list included in the system information file, a signal that matches conditions of the test scenario, has an update bit, and has a transmission period shorter than the transmission period of at least one other signal as a test target signal. The update bit is a flag that is transmitted in the same CAN message as the associated signal and is set at 1 when the value of that signal is updated and is cleared to 0 when the value is not updated for transmission. Next, the process at step S42 is performed.

At step S42, the extraction unit 111 calculates a least common multiple of the transmission period of all signals stored in the same CAN message as that of the selected test target signal as reception continuation time. Next, the process at step S43 is performed.

At step S43, the extraction unit 111 extracts, from the system information file, a signal ID for identifying the selected test target signal, a signal type, a signal length, an initial value, and position information in the CAN message of the update bit associated with the test target signal. Next, the process at step S44 is performed.

At step S44, the extraction unit 111 stores the reception continuation time calculated at step S42 and the signal related information extracted at step S43 in the memory 102, and ends the operation.

Since the operation of the determination unit 112 is identical to that of Embodiment 1, description is omitted.

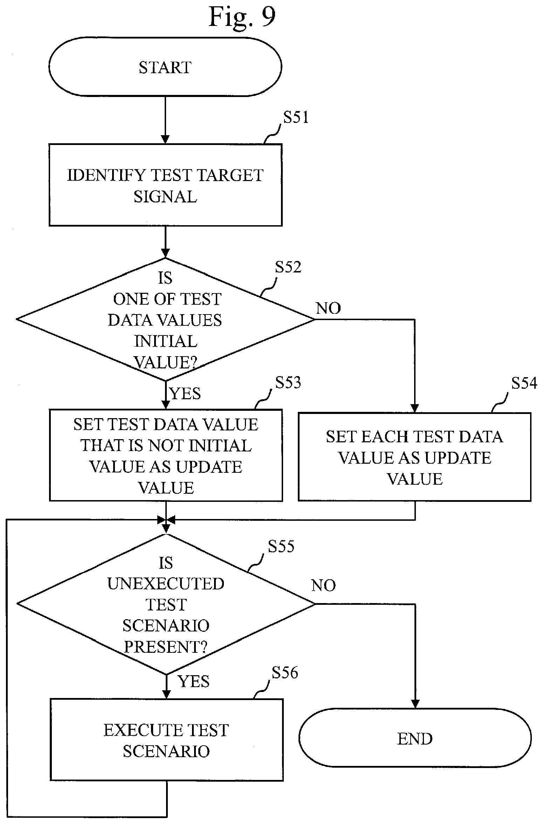

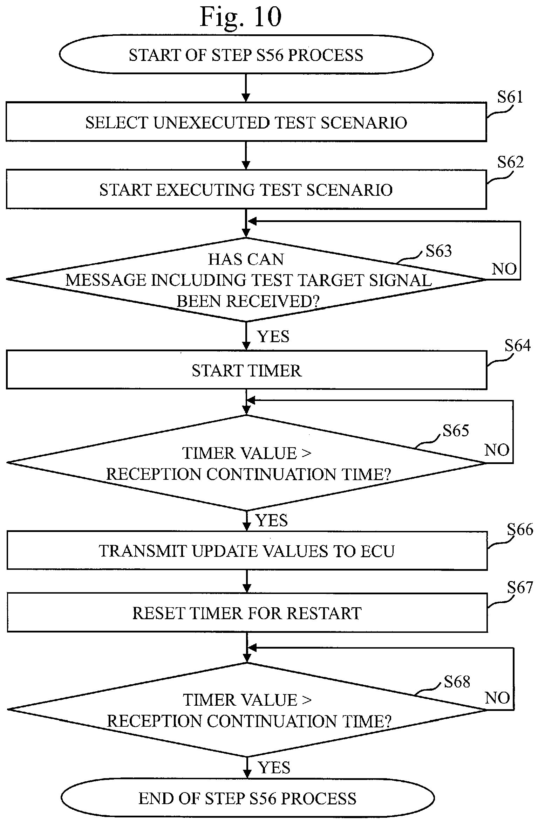

The operation of the execution unit 113 is described by using Fig. 9 and Fig. 10.

At step S51, the execution unit 113 identifies the test target signal by using the signal ID from the signal related information extracted by the extraction unit 111. Next, the process at step S52 is performed.

At step S52, the execution unit 113 checks whether the initial value of the test target signal is included in two test data values determined by the determination unit 112. If included, the process at step S53 is performed. If not included, the process at step S54 is performed.

At step S53, the execution unit 113 takes a value of the test data values that is not the initial value as an update value. Next, the process at step S55 is performed.

At step S54, the execution unit 113 determines to execute the test scenario twice. The execution unit 113 takes the two test data values as update values in the first and second test scenario executions, respectively. Next, the process at step S55 is performed.

At step S55, the execution unit 113 checks whether all test scenarios have been executed. If an unexecuted test scenario is present, the process at step S56 is performed. If executions of all test scenarios have been completed, the operation ends.

The process at step S56 is performed by the following procedure.

At step S61, the execution unit 113 selects an unexecuted test scenario. Next, the process at step S62 is performed.

At step S62, the execution unit 113 starts executing a test via the communication unit 116 by using the test target signal and the update values by following the test scenario. Next, the process at step S63 is performed.

At step S63, the execution unit 113 waits until the judgment unit 114 receives a test target signal included in a CAN message transmitted by the ECU 200 via the communication unit 116. Upon reception, the process at step S64 is performed.

At step S64, the execution unit 113 starts a timer. Next, the process at step S65 is performed.

At step S65, the execution unit 113 uses the timer and waits until the reception continuation time elapses. This allows the judgment unit 114 to receive the CAN message having the test target signal with the initial value stored therein for the reception continuation time. When the reception continuation time elapses, the process at step S66 is performed.

At step S66, the execution unit 113 passes the update values via the communication unit 116 to the ECU 200. Next, the process at step S67 is performed.

At step S67, the execution unit 113 resets the timer for restart. Next, the process at step S68 is performed.

At step S68, the execution unit 113 uses the timer and waits again until the reception continuation time elapses. This allows the judgment unit 114 to receive the CAN message having the test target signal with the update values stored therein for the reception continuation time. When the reception continuation time elapses, the execution unit 113 completes execution of the test scenario.

After the process at step S56, the process at step S55 is performed again.

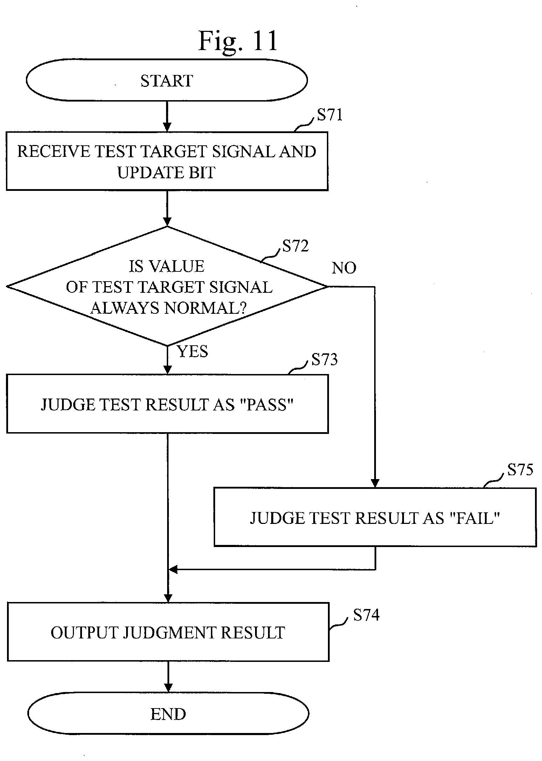

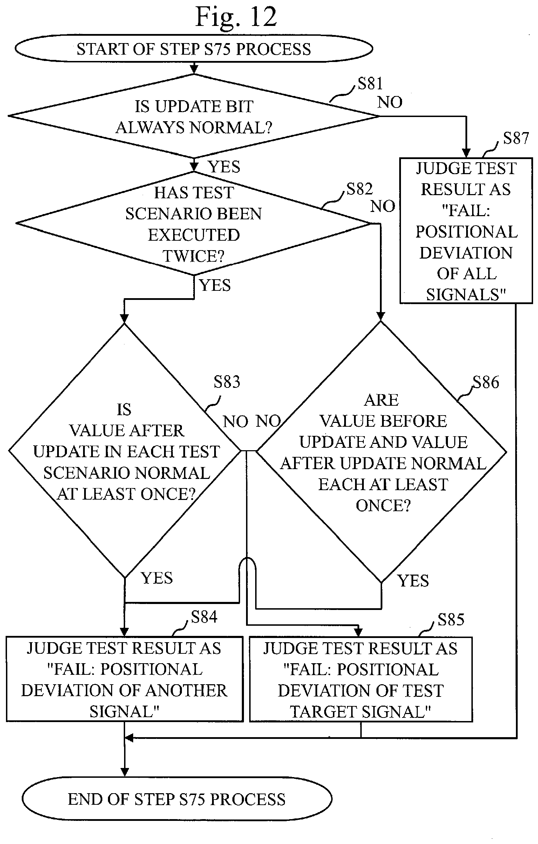

The operation of the judgment unit 114 and the output unit 115 is described by using Fig. 11 and Fig. 12. For test judgment, a portion for judging a time interval of the received CAN message and so forth and other portions may be included depending on the test scenario. Here, only a judgment portion regarding the value of the signal is described.

At step S71, the judgment unit 114 receives a test target signal and an update bit included in the CAN message transmitted by the ECU 200 via the communication unit 116 from the start to end of the operation of the execution unit 113. When test execution is completed, the process at step S72 is performed.

At step S72, the judgment unit 114 checks whether all values of the received test target signals match an expected value. If they match, the process at step S73 is performed. If there is a reception value that does not match the expected value, the process at step S75 is performed.

At step S73, the judgment unit 114 takes the judgment result of the value of the test target signal as "PASS". Next, the process at step S74 is performed.

At step S74, the output unit 115 outputs the test judgment result at the judgment unit 114, and ends the operation.

The process at step S75 is performed by the following procedure.

At step S81, the judgment unit 114 checks the update bit. If the value of the update bit is 0 before the test target signal is updated, 1 after update and at first reception, and then 0, the judgment unit 114 judges that the update bit is normal. Next, the process at step S82 is performed. The process at step S87 is performed otherwise.

At step S82, the judgment unit 114 checks if the test scenario has been executed twice at the execution unit 113. If executed twice, the process at step S83 is performed. If executed once, the process at step S86 is performed.

At step S83, the judgment unit 114 judges whether in each of the two test scenarios, the reception value after the update value is transmitted by the execution unit 113 matches the expected value at least once. If they match, the process at step S84 is performed. If they do not match, the process at step S85 is performed.

At step S84, the judgment unit 114 takes the judgment result of the value of the test target signal as "FAIL" and takes the cause of "FAIL" as possibility of positional deviation of another signal. Next, the process at step S74 is performed.

At step S85, the judgment unit 114 takes the judgment result of the value of the test target signal as "FAIL" and takes the cause of "FAIL" as possibility of positional deviation of the test target signal. Next, the process at step S74 is performed.

At step S86, the judgment unit 114 judges whether the reception value before transmission of the update value by the execution unit 113 matches the initial value at least once and the reception value after transmission also matches the update value at least once. If they match, the process at step S84 is performed. If they do not match, the process at step S85 is performed.

At step S87, since the value of the test target signal and the value of the update bit are abnormal, the judgment unit 114 judges that the arrangement of all signals is abnormal. The judgment unit 114 then takes the judgment result of the test target signal as "FAIL" and takes the cause of "FAIL" as possibility of positional deviation of all signals. Next, the process at step S74 is performed.

As described above, at step S56, the communication unit 116 sequentially receives messages partially including a test target signal of a plurality of bits transmitted from the ECU 200 as a test target device. At step S72, the judgment unit 114 checks the value of a test target signal included in a message received by the communication unit 116 in a first duration against a first expected value. The judgment unit 114 checks the value of a test target signal included in a message received by the communication unit 116 in a second duration different from the first duration against a second expected value acquired by inverting each bit of the first expected value. At step S73 and step S75, the judgment unit 114 judges the test on the ECU 200 as pass or fail based on both of the check results.

In the present embodiment, the message including the test target signal includes an update bit indicating whether the value of the test target signal has been updated. At step S81, the judgment unit 114 checks the value of the update bit included in the message received by the communication unit 116 against a fourth expected value. At step S73 and step S75, the judgment unit 114 judges the test on the ECU 200 as pass or fail based on the check result of the value of the test target signal and the check result of the value of the update bit. Specifically, the judgment unit 114 judges the test on the ECU 200 as pass or fail based on the results of checking the value of the test target signal in the first duration against the first expected value, the value of the test target signal in the second duration against the second expected value, and the values of the update bit in the first duration and the second duration against the fourth expected value.

In the present embodiment, for each individual period, the test target signal and another one or more signals are included in the message transmitted from the ECU 200. The period of the test target signal is different from the periods of any other signals. Specifically, the period of the test target signal is shorter than the periods of any other signals. At step S56, the communication unit 116 receives any other signals each at least once during execution of the test on the ECU 200.

The operation of the test device 100 is described by using a specific example. A test scenario is assumed to be identical to that in the example used for the description of Embodiment 1.

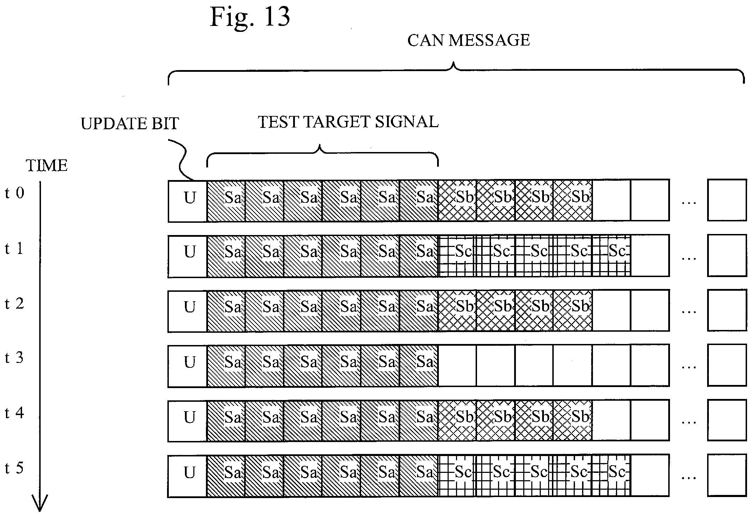

In this example, in the system information file, a periodically-transmitted CAN message and unsigned integer-type signal Sa included therein and having a 6-bit length and initial value of 3 (000011b). Also, an update bit associated with this signal Sa is present. Furthermore, as signals adjacent to the signal Sa, a signal Sb and a signal Sc having different periods are present. The structure for each transmission of this CAN message including the signal Sa is illustrated in Fig. 13. In the drawing, "U" indicates the position of the update bit. While the update bit is adjacent to the test target signal in the present embodiment, the update bit may not be adjacent thereto. As illustrated in Fig. 13, the signal Sa is transmitted for each period. That is, the period of the signal Sa is 1. The period of the signal Sb is 2, and the period of the signal Sc is 4. The extraction unit 111 extracts the signal Sa of the shortest period as a test target signal. The reception continuation time is a time corresponding to the period of 4, which is a least common multiple. The test data determination method and test execution method for the signal Sa are identical to those of Embodiment 1. Thus, for the initial value of 3, an update value of 60 is determined. For test execution, since the period is 4, if the test result is normal, the test target signal is transmitted with the initial value for four CAN messages, and is transmitted with the update value thereafter until test execution is completed.

In this example, the operation of the judgment unit 114 when PF and the system information file are normal is identical to that of Embodiment 1, and therefore description is omitted.

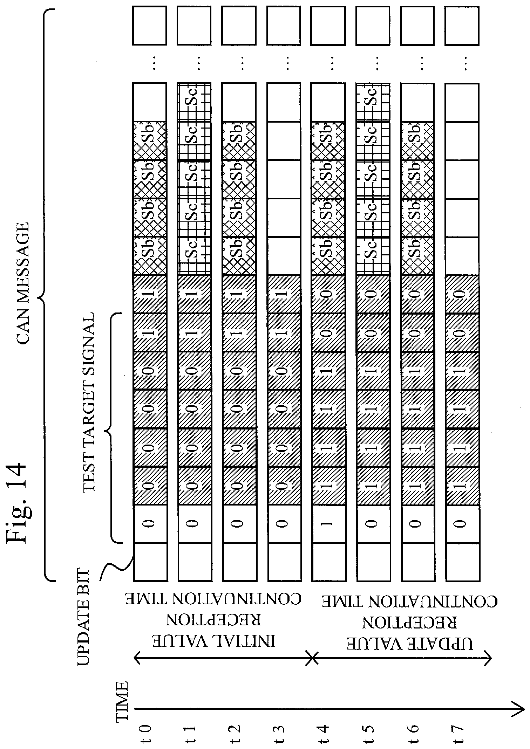

The case in which the process of arrangement of the signal inside the PF to the CAN message has a failure and the positions of all signals included in the CAN message are deviated by one bit is described by using Fig. 14.

With the positions of the test target signal and the update bit deviated, the value of the test target signal and the value of the update bit received by the judgment unit 114 are different from the expected value during the reception continuation time of the initial value and the update value. Thus, the judgment unit 114 judges the test result as "FAIL" and the cause of "FAIL" as possibility of positional deviation of all signals, and ends the operation.

In this manner, by selecting the signal Sa associated with the update bit as a test target signal and using the value of the test target signal and the value of the update bit for judgment at the time of the test, it is possible to judge that there is a high possibility that the cause of the failure is positional deviation of all signals.

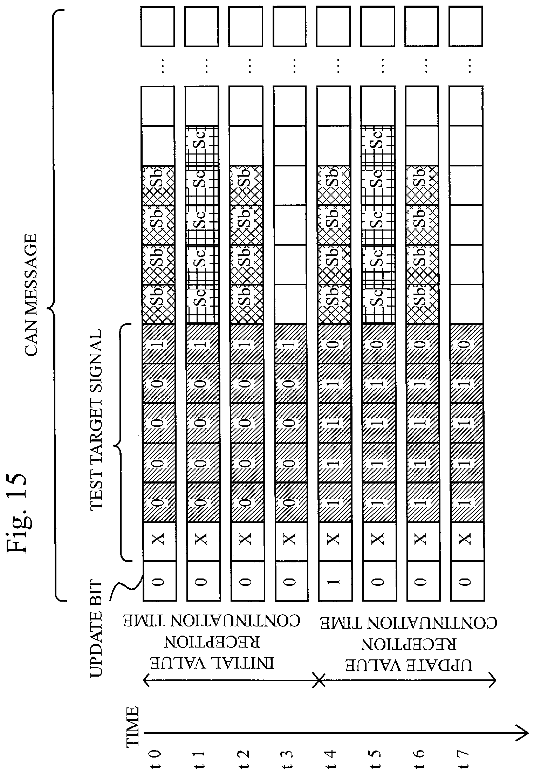

The case in which the system information file has a failure and the position of the test target signal in the CAN message is deviated by one bit is described by using Fig. 15.

During the reception continuation time of the initial value and the update value, the value of the test target signal is different from the expected value, but the value of the update bit is normal. Thus, the judgment unit 114 judges whether the value of the test target signal received as an initial value and the value of the test target signal received as an update value match the initial value of 3 and the update value of 60 as expected values, respectively, at least once. Here, in Fig. 15, X is a value fixed at either 0 or 1. When X is 0, the value received as an initial value during the reception continuation time of the initial value is always 1, and never becomes the expected value of 3. That is, the value of the test target signal never becomes a normal value. Therefore, since the condition is not satisfied, the judgment unit 114 judges the test result as "FAIL" and the cause of "FAIL" as possibility of positional deviation of the test target signal, and ends the operation.

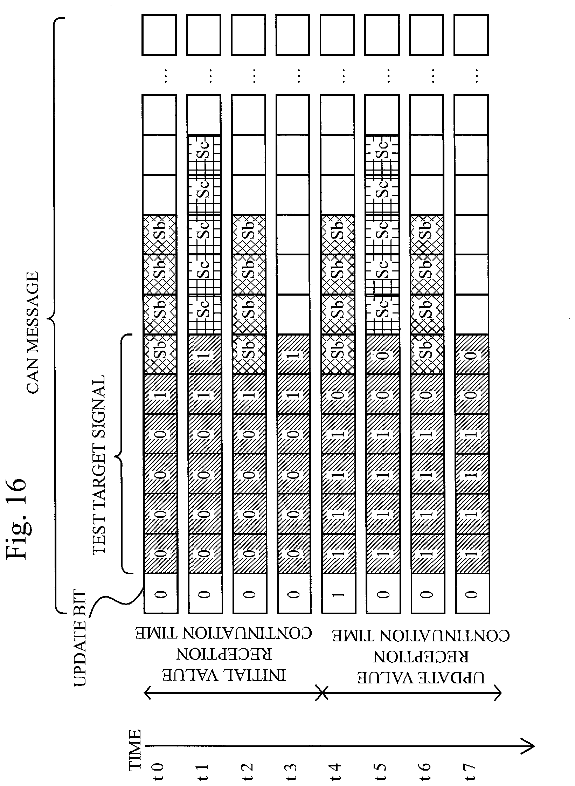

The case in which the system information file has a failure and the position of a signal Sb in the CAN message is deviated by one bit to overlap the last one bit of the test target signal is described by using Fig. 16.

During the reception continuation time of the initial value and the update value, the value of the test target signal is different from the expected value, but the value of the update bit is normal. Thus, the judgment unit 114 judges whether the value of the test target signal received as an initial value and the value of the test target signal received as an update value match the initial value of 3 and the update value of 60 as expected values, respectively, at least once. Here, the first one bit of the signal Sb is a value fixed at either 0 or 1. When this value is 1, the value received as an initial value during the reception continuation time of the initial value is always 3, matching the expected value. That is, the value of the test target signal matches a normal value. During the reception continuation time of the update value, with respect to the expected value of 60 (111100b), the reception value is 61 (111101b) at time t4 and t6 and the reception value is 60 (111100b) at other times. Thus, during both of the reception continuation times, the reception value matches the expected value at least once. Therefore, the judgment unit 114 judges the test result as "FAIL" and the cause of "FAIL" as possibility of positional deviation of another signal, and ends the operation.

In this manner, by selecting a test target signal from the signal Sa, the signal Sb, and the signal Sc having different transmission periods included in the same CAN message, it is possible to identify whether the cause of the failure is positional deviation of the test target signal or overlapping with the test target signal due to positional deviation of another signal. Furthermore, by selecting the signal Sa having the shortest period as a test target signal, the ratio of detecting a failure due to positional deviation of another signal can be increased.

In the present embodiment, by setting a least common multiple of the respective signal periods as reception continuation time, each signal is transmitted at least once during test execution. Thus, the ratio of detecting a failure due to positional deviation of another signal can be increased.

Note that while the test scenario is executed once and the initial value and the update value are bit-inversed with each other in the above-described example, a similar judgment can be made also when the test scenario is executed twice and their update values are bit-inversed with each other.

### ***Description of Effects of Embodiment***

In the present embodiment, a signal associated with the update bit is selected as a test target signal, and the update bit in addition to the test target signal is also taken as a monitoring target for executing the test. Thus, it is possible to more reliably judge from the test result whether the cause of the failure is positional deviation of all signals. If it has been found that there is a high possibility of positional deviation of all signals, it is possible to perform analysis by assuming that the failure is in the process associated with PF signal arrangement. This allows reduction in time for investigating the cause of the failure and reduction in the number of development steps.

In the present embodiment, by selecting a signal from the CAN message including signals of a plurality of periods as a test target signal, the probability of identifying from the test result whether the cause of the failure is positional deviation of the test target signal or overlapping with the test target signal due to positional deviation of another signal can be increased. If it has been found that there is a high possibility of such positional deviation, it is possible to perform analysis by assuming that the failure is in the signal arrangement information of the system information file. This allows reduction in time for investigating the cause of the failure and reduction in the number of development steps.

In the present embodiment, a signal of the shortest period is selected from among signals of a plurality of periods. Thus, the probability of detection of positional deviation of another signal can be further increased.

In the present embodiment, by executing the test so that all signals transmitted in the same CAN message as that of the test target signal are transmitted at least once, the ratio of detecting overlapping with the test target signal due to positional deviation of another signal can be increased.

### ***Other Configurations***

In the present embodiment, the extraction unit 111 uses the least common multiple of the signal period as reception continuation time. However, if offset time until transmission starts is present, the reception continuation time may be determined in consideration of this offset time.

### Reference Signs List

100: test device; 101: processor; 102: memory; 103: CAN communication device; 104: serial communication device; 105: input/output device; 106: internal bus; 111: extraction unit; 112: determination unit; 113: execution unit; 114: judgment unit; 115: output unit; 116: communication unit; 200: ECU

## Claims

1. A test device (100) comprising:
a communication unit (116) to sequentially receive messages partially including a test target signal of a plurality of bits transmitted from a test target device; and
a judgment unit (114) to check a value of the test target signal included in a message received by the communication unit (116) in a first duration against a first expected value, to check a value of the test target signal included in a message received by the communication unit (116) in a second duration different from the first duration against a second expected value acquired by inverting each bit of the first expected value, and to judge a test on the test target device as pass or fail based on both of the check results,
wherein the judgment unit (114) is further configured to check a value of a signal adjacent to the test target signal in the message received by the communication unit (116) against a third expected value, and judge the test on the test target device as pass or fail based on the check result of the value of the test target signal and the check result of the value of the signal adjacent to the test target signal.

2. The test device (100) according to claim 1, further comprising:
a determination unit (112) to determine an initial value of the test target signal as the first expected value, to compute a value acquired by inverting each bit of the initial value, and to determine the computation result as the second expected value.

3. The test device (100) according to claim 2, wherein
when at least either of the initial value and the computation result is out of a range of the test target signal, the determination unit (112) determines a first setting value which is in the range and is different from the initial value as the first expected value and determines a second setting value which is in the range and is acquired by inverting each bit of the first setting value as the second expected value.

4. The test device (100) according to any one of claims 1 to 3, wherein
the message including the test target signal includes an update bit indicating whether the value of the test target signal has been updated, and
the judgment unit (114) checks a value of the update bit included in the message received by the communication unit (116) against a fourth expected value, and judges the test on the test target device as pass or fail based on the check result of the value of the test target signal and the check result of the value of the update bit.

5. The test device (100) according to any one of claims 1 to 4, wherein
the test target signal and another one or more signals are included, in individual period, in the message transmitted from the test target device, and
a period of the test target signal is different from periods of any other signals.

6. The test device (100) according to claim 5, wherein
the period of the test target signal is shorter than the periods of any other signals.

7. The test device (100) according to claim 5 or 6, wherein
the communication unit (116) receives any other signals each at least once during execution of the test on the test target device.

8. The test device (100) according to any one of claims 1 to 7, further comprising:
an execution unit (113) to notify the test target device of the first expected value and the second expected value.

9. A test method comprising:
by a test target device, sequentially transmitting messages partially including a test target signal of a plurality of bits;
by a test device (100), sequentially receiving the messages transmitted from the test target device; and
by the test device (100), checking a value of the test target signal included in a message received in a first duration against a first expected value, checking a value of the test target signal included in a message received in a second duration different from the first duration against a second expected value acquired by inverting each bit of the first expected value, checking a value of a signal adjacent to the test target signal in the message against a third expected value, and judging a test on the test target device as pass or fail based on the check results of the value of the test target signal and the check result of the value of the signal adjacent to the test target signal.

10. A test program that causes a computer to execute:
a process of sequentially receiving messages partially including a test target signal of a plurality of bits transmitted from a test target device; and
a process of checking a value of the test target signal included in a message received in a first duration against a first expected value, checking a value of the test target signal included in a message received in a second duration different from the first duration against a second expected value acquired by inverting each bit of the first expected value, checking a value of a signal adjacent to the test target signal in the message against a third expected value, and judging a test on the test target device as pass or fail based on the check results of the value of the test target signal and the check result of the value of the signal adjacent to the test target signal.

## Patentansprüche

1. Testeinrichtung (100), umfassend:
eine Kommunikationseinheit (116) zum sequentiellen Empfangen von Nachrichten, die teilweise ein Testzielsignal aus einer Vielzahl von Bits aufweisen, das von einer Testzieleinrichtung übertragen wird; und
eine Beurteilungseinheit (114), um einen Wert des Testzielsignals, das in einer von der Kommunikationseinheit (116) in einer ersten Zeitdauer empfangenen Nachricht enthalten ist, gegen einen ersten erwarteten Wert zu prüfen, um einen Wert des Testzielsignals, das in einer von der Kommunikationseinheit (116) in einer zweiten Zeitdauer, die sich von der ersten Zeitdauer unterscheidet, empfangenen Nachricht enthalten ist, gegen einen zweiten erwarteten Wert zu prüfen, der durch Invertieren jedes Bits des ersten erwarteten Wertes erworben wird, und um einen Test an der Testzieleinrichtung auf Grundlage beider Prüfergebnisse als bestanden oder nicht bestanden zu beurteilen,
wobei die Beurteilungseinheit (114) ferner eingerichtet ist, einen Wert eines zu dem Testzielsignal benachbarten Signals in der von der Kommunikationseinheit (116) empfangenen Nachricht gegen einen dritten erwarteten Wert zu prüfen und den Test an der Testzieleinrichtung auf Grundlage des Prüfergebnisses des Werts des Testzielsignals und des Prüfergebnisses des Werts des zu dem Testzielsignal benachbarten Signals als bestanden oder nicht bestanden zu beurteilen.

2. Testeinrichtung (100) nach Anspruch 1, ferner umfassend:
eine Bestimmungseinheit (112), um einen Anfangswert des Testzielsignals als den ersten erwarteten Wert zu bestimmen, um einen durch Invertieren jedes Bits des Anfangswerts erworbenen Wert zu berechnen und um das Berechnungsergebnis als den zweiten erwarteten Wert zu bestimmen.

3. Testeinrichtung (100) nach Anspruch 2, wobei
wenn zumindest entweder der Anfangswert oder das Berechnungsergebnis außerhalb eines Bereichs des Testzielsignals liegt, die Bestimmungseinheit (112) einen ersten Einstellwert bestimmt, der in dem Bereich liegt und sich von dem Anfangswert als der erste erwartete Wert unterscheidet, und einen zweiten Einstellwert, der in dem Bereich liegt und durch Invertieren jedes Bits des ersten Einstellwerts erfasst wird, als den zweiten erwarteten Wert bestimmt.

4. Testeinrichtung (100) nach einem der Ansprüche 1 bis 3, wobei
die Nachricht, die das Testzielsignal aufweist, ein Aktualisierungsbit aufweist, das anzeigt, ob der Wert des Testzielsignals aktualisiert wurde, und
die Beurteilungseinheit (114) einen Wert des Aktualisierungsbits, das in der von der Kommunikationseinheit (116) empfangenen Nachricht enthalten ist, gegen einen vierten erwarteten Wert prüft und den Test an der Testzieleinrichtung auf Grundlage des Prüfergebnisses des Werts des Testzielsignals und des Prüfergebnisses des Werts des Aktualisierungsbits als bestanden oder nicht bestanden beurteilt.

5. Testeinrichtung (100) nach einem der Ansprüche 1 bis 4, wobei
das Testzielsignal und ein weiteres oder mehr Signale in individueller Periode in der von der Testzieleinrichtung übertragenen Nachricht enthalten sind, und
sich eine Periode des Testzielsignals von Perioden aller anderen Signale unterscheidet.

6. Testeinrichtung (100) nach Anspruch 5, wobei
die Periode des Testzielsignals kürzer ist als die Perioden aller anderen Signale.

7. Testeinrichtung (100) nach Anspruch 5 oder 6, wobei
die Kommunikationseinheit (116) alle anderen Signale jeweils zumindest einmal während einer Ausführung des Tests an der Testzieleinrichtung empfängt.

8. Testeinrichtung (100) nach einem der Ansprüche 1 bis 7, ferner umfassend:
eine Ausführungseinheit (113) zum Benachrichtigen der Testzieleinrichtung über den ersten erwarteten Wert und den zweiten erwarteten Wert.

9. Testverfahren, umfassend:
durch eine Testzieleinrichtung, sequentielles Übertragen von Nachrichten, die teilweise ein Testzielsignal aus einer Vielzahl von Bits aufweisen;
durch eine Testeinrichtung (100), sequentielles Empfangen der von der Testzieleinrichtung übertragenen Nachrichten; und
durch eine Testeinrichtung (100), Prüfen eines Werts des Testzielsignals, das in einer Nachricht enthalten ist, die in einer ersten Zeitdauer empfangen wird, gegen einen ersten erwarteten Wert, Prüfen eines Werts des Testzielsignals, das in einer Nachricht enthalten ist, die in einer zweiten Zeitdauer, die sich von der ersten Zeitdauer unterscheidet, empfangen wird, gegen einen zweiten erwarteten Wert, der durch Invertieren jedes Bits des ersten erwarteten Werts erworben wird, Prüfen eines Werts eines Signals, das zu dem Testzielsignal in der Nachricht benachbart ist, gegen einen dritten erwarteten Wert, und Beurteilen eines Tests an der Testzieleinrichtung auf Grundlage der Prüfergebnisse des Werts des Testzielsignals und des Prüfergebnisses des Werts des zu dem Testzielsignal benachbarten Signals als bestanden oder nicht bestanden.

10. Testprogramm, das einen Computer veranlasst, auszuführen:
einen Prozess des sequentiellen Empfangens von Nachrichten, die teilweise ein Testzielsignal aus einer Vielzahl von Bits aufweisen, die von einer Testzieleinrichtung übertragen werden; und
einen Prozess des Prüfens eines Werts des Testzielsignals, das in einer Nachricht enthalten ist, die in einer ersten Zeitdauer empfangen wird, gegen einen ersten erwarteten Wert, Prüfen eines Werts des Testzielsignals, das in einer Nachricht enthalten ist, die in einer zweiten Zeitdauer, die sich von der ersten Zeitdauer unterscheidet, empfangen wird, gegen einen zweiten erwarteten Wert, der durch Invertieren jedes Bits des ersten erwarteten Wertes erworben wird, Prüfen eines Werts eines Signals, das zu dem Testzielsignal in der Nachricht benachbart ist, gegen einen dritten erwarteten Wert, und Beurteilen eines Tests an der Testzieleinrichtung auf Grundlage der Prüfergebnisse des Werts des Testzielsignals und des Prüfergebnisses des Werts des zu dem Testzielsignal benachbarten Signals als bestanden oder nicht bestanden.

## Revendications

1. Dispositif de test (100) comprenant :
une unité de communication (116) destinée à recevoir séquentiellement des messages incluant partiellement un signal cible de test d'une pluralité de bits transmis à partir d'un dispositif cible de test ; et
une unité d'évaluation (114) destinée à vérifier une valeur du signal cible de test inclus dans un message reçu par l'unité de communication (116) au cours d'une première durée par rapport à une première valeur attendue, à vérifier une valeur du signal cible de test inclus dans un message reçu par l'unité de communication (116) au cours d'une seconde durée différente de la première durée par rapport à une deuxième valeur attendue acquise en inversant chaque bit de la première valeur attendue, et à évaluer un test sur le dispositif cible de test, comme correspondant à une réussite ou un échec, sur la base des deux résultats de vérification ;
dans lequel l'unité d'évaluation (114) est en outre configurée de manière à vérifier une valeur d'un signal adjacent au signal cible de test dans le message reçu par l'unité de communication (116), par rapport à une troisième valeur attendue, et à évaluer le test, sur le dispositif cible de test, comme correspondant à une réussite ou un échec, sur la base du résultat de vérification de la valeur du signal cible de test et du résultat de vérification de la valeur du signal adjacent au signal cible de test.

2. Dispositif de test (100) selon la revendication 1, comprenant en outre :
une unité de détermination (112) destinée à déterminer une valeur initiale du signal cible de test comme étant la première valeur attendue, à calculer une valeur acquise en inversant chaque bit de la valeur initiale, et à déterminer le résultat de calcul comme étant la deuxième valeur attendue.

3. Dispositif de test (100) selon la revendication 2, dans lequel :
lorsqu'au moins l'un(e) ou l'autre de la valeur initiale et du résultat de calcul est en dehors de la plage du signal cible de test, l'unité de détermination (112) détermine une première valeur de réglage qui se situe dans la plage et qui est différente de la valeur initiale, comme étant la première valeur attendue, et détermine une seconde valeur de réglage qui se situe dans la plage et qui est acquise en inversant chaque bit de la première valeur de réglage, comme étant la deuxième valeur attendue.

4. Dispositif de test (100) selon l'une quelconque des revendications 1 à 3, dans lequel
le message incluant le signal cible de test inclut un bit de mise à jour indiquant si la valeur du signal cible de test a été mise à jour; et
l'unité d'évaluation (114) vérifie une valeur du bit de mise à jour inclus dans le message reçu par l'unité de communication (116), par rapport à une quatrième valeur attendue, et évalue le test, sur le dispositif cible de test, comme correspondant à une réussite ou à un échec, sur la base du résultat de vérification de la valeur du signal cible de test et du résultat de vérification de la valeur du bit de mise à jour.

5. Dispositif de test (100) selon l'une quelconque des revendications 1 à 4, dans lequel :
le signal cible de test et un ou plusieurs autres signaux sont inclus, au cours d'une période individuelle, dans le message transmis par le dispositif cible de test; et
une période du signal cible de test est différente de périodes d' autres signaux quelconques.

6. Dispositif de test (100) selon la revendication 5, dans lequel :
la période du signal cible de test est plus courte que les périodes des autres signaux quelconques.

7. Dispositif de test (100) selon la revendication 5 ou 6, dans lequel :
l'unité de communication (116) reçoit chacun des autres signaux quelconques au moins une fois pendant l'exécution du test sur le dispositif cible de test.

8. Dispositif de test (100) selon l'une quelconque des revendications 1 à 7, comprenant en outre :
une unité d'exécution (113) destinée à notifier, au dispositif cible de test, la première valeur attendue et la deuxième valeur attendue.

9. Procédé de test comprenant:
par le biais d'un dispositif cible de test, la transmission séquentiellement des messages incluant partiellement un signal cible de test d'une pluralité de bits ;
par le biais d'un dispositif de test (100), la récetion séquentiellement des messages transmis à partir du dispositif cible de test ; et
par le biais du dispositif de test (100), la vérificatoni d'une valeur du signal cible de test inclus dans un message reçu au cours d'une première durée, par rapport à une première valeur attendue, la vérification d'une valeur du signal cible de test inclus dans un message reçu au cours d'une seconde durée, différente de la première durée, par rapport à une deuxième valeur attendue acquise en inversant chaque bit de la première valeur attendue, la vérification d'une valeur d'un signal adjacent au signal cible de test dans le message, par rapport à une troisième valeur attendue, et l'évaluation d'un test sur le dispositif cible de test comme correspondant à une réussite ou à un échec, sur la base des résultats de vérification de la valeur du signal cible de test et du résultat de vérification de la valeur du signal adjacent au signal cible de test.

10. Programme de test qui amène un ordinateur à exécuter :
un processus consistant à recevoir séquentiellement des messages incluant partiellement un signal cible de test d'une pluralité de bits transmis à partir d'un dispositif cible de test ; et
un processus consistant à vérifier une valeur du signal cible de test inclus dans un message reçu au cours d'une première durée, par rapport à une première valeur attendue, à vérifier une valeur du signal cible de test inclus dans un message reçu au cours d'une seconde durée, différente de la première durée, par rapport à une deuxième valeur attendue acquise en inversant chaque bit de la première valeur attendue, à vérifier une valeur d'un signal adjacent au signal cible de test dans le message, par rapport à une troisième valeur attendue, et à évaluer un test sur le dispositif cible de test comme correspondant à une réussite ou à un échec, sur la base des résultats de vérification de la valeur du signal cible de test et du résultat de vérification de la valeur du signal adjacent au signal cible de test.
